# EUROPÄISCHE PATENTANMELDUNG

(11) **EP 2 543 673 A1**
(43) Veröffentlichungstag der Anmeldung: **09.01.2013**
(21) Anmeldenummer: 11179112.5
(22) Anmeldetag: 26.08.2011
(51) Int. Cl.: C07F 1/08, H01L 51/00

(54) **Kupfer(I)komplexe für opto-elektronische Vorrichtungen**

(30) Priorität: 08.07.2011 EP 11173371; 05.08.2011 EP 11176760
(71) Anmelder: cynora GmbH, 76344 Eggenstein-Leopoldshafen (DE)
(72) Erfinder: Baumann, Thomas, 76131 Karlsruhe (DE); Grab, Tobias, 76133 Karlsruhe (DE); Bergmann, Larissa, 76133 Karlsruhe (DE)
(74) Vertreter: Hoppe, Georg Johannes

(57) **Zusammenfassung**

Die Erfindung betrifft Kupfer(I)komplex zur Emission von Licht mit einer Struktur gemäß Formel A 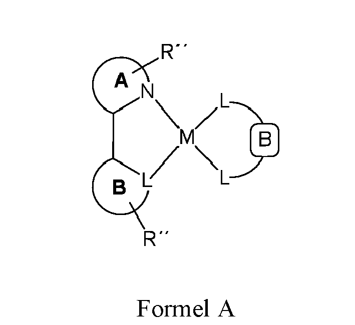 wobei 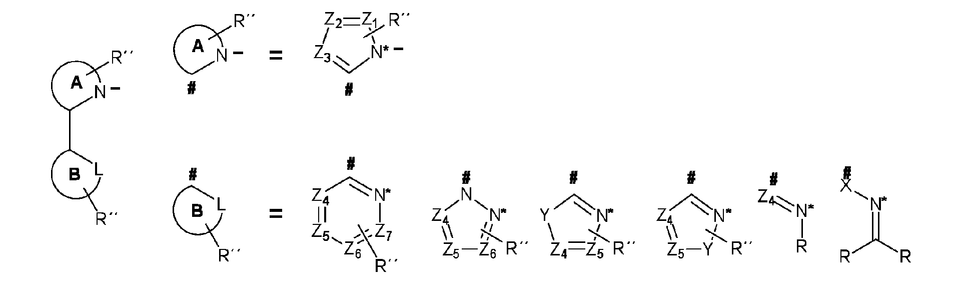 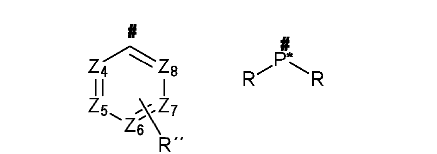 wobei gilt:
● M ist Cu(I);
● L-B-L: ein neutraler, zweizähniger Ligand,
● Z1-Z7: besteht aus N oder dem Fragment CR,
mit R = organischer Rest, der ausgewählt ist aus der Gruppe bestehend aus:
Wasserstoff, Halogen oder Gruppen, die über Sauerstoff (OR), Stickstoff (NR₂) oder Phosphor (PR₂) gebunden sind sowie Alkyl-, Aryl-, Heteroaryl-, Alkenyl-, Alkinyl-, Trialkylsilyl- und Triarylsilyl-Gruppen oder substituierte Alkyl-, Aryl-, Heteroaryl- und Alkenyl-Gruppen mit Substituenten wie Halogenen, niedrigen Alkylgruppen;

● X ist entweder CR₂ oder NR;
● Y ist entweder O, S oder NR;
● Z8 besteht aus dem Fragment CR',
mit R' = OR, NR₂ oder PR₂, wobei die Bindung zum Cu-Atom dann über diese Gruppen erfolgt;
● R" ist ein sterisch anspruchsvoller Substituent, bevorzugt in ortho-Position zur Koordinationsstelle, der eine Geometrieveränderung in Richtung einer Planarisierung des Komplexes im angeregten Zustand verhindert, bevorzugt ein Alkylrest -(CH2)ₙ-CH₃ (n = 0 - 20) (auch verzweigt), ein Arylrest mit 6 - 20 Kohlenstoffatomen (z. B. - Ph), Alkoxyrest -O-(CH₂)ₙ-CH₃ (n = 0 - 20), ein Aryloxyrest (z. B. -OPh) oder ein Silanrest (z. B -SiMe₃), wobei die Alkyl- und Arylreste auch substituiert sein können (z. B. mit Halogenen, Alkoxy- oder Silan-Gruppen) und optional zu annelierten Ringsystemen führen,
wobei Formel keinen, einen oder zwei Reste R" aufweist;
● "*" kennzeichnet das Atom, das die Komplexbindung eingeht; und
● "#" kennzeichnet das Atom, das die Bindung mit der zweiten chemischen Einheit vermittelt.

## Beschreibung

Die vorliegende Erfindung betrifft die Verwendung von Kupfer(I)komplexen (Cu(I)-Komplexen) als Emitter in OLEDs (organic light emitting diodes) und in anderen opto-elektronischen Vorrichtungen.

### Einleitung

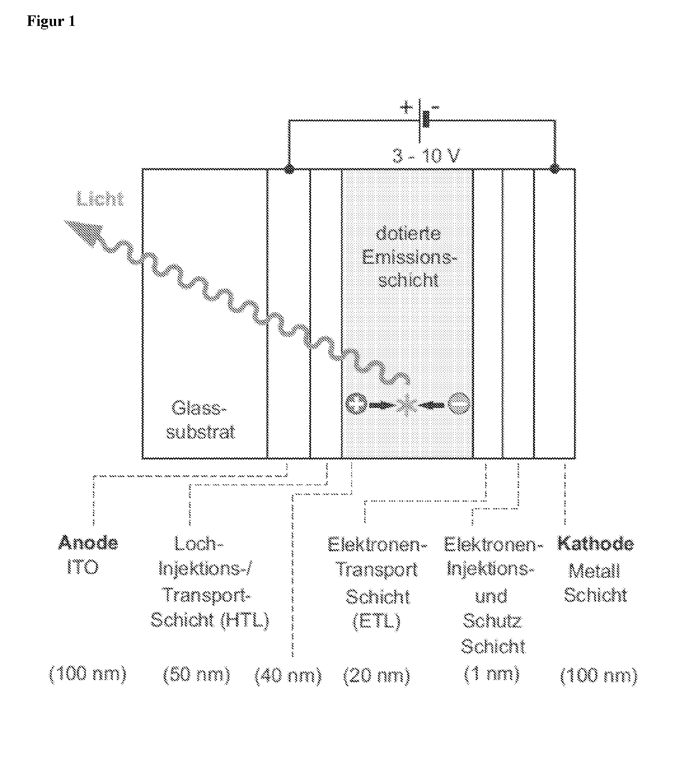

OLEDs eignen sich prinzipiell hervorragend zur Herstellung großflächiger Beleuchtungs- und Displayanwendungen, finden sich im Augenblick aufgrund aufwendiger Herstellungsverfahren jedoch nur in kleinformatigen Geräten wieder. OLEDs werden in der Regel in Schichtenstrukturen realisiert. Zum besseren Verständnis ist in Fig. 1 ein prinzipieller Aufbau eines OLEDs gezeigt. Aufgrund der angelegten äußeren Spannung an einer transparenten Indium-Zinn-Oxid-Anode (ITO) und einer dünnen Metall-Kathode werden von der Anode positive Löcher und von der Kathode negative Elektronen injiziert. Diese verschieden geladenen Ladungsträger gelangen über Zwischenschichten, zu denen auch hier nicht gezeichnete Loch- bzw. Elektronen-Blockierschichten gehören können, in die Emissionsschicht. Dort treffen die entgegengesetzt geladenen Ladungsträger an oder in der Nähe von dotierten Emitter-Molekülen zusammen und rekombinieren. Die Emitter-Moleküle sind in der Regel in Matrix-Molekülen oder Polymermatrizen (in z. B. 2 bis 10 Gew.-%) eingelagert, wobei die Matrix-Materialien so gewählt sind, dass sie auch einen Loch- und Elektronentransport ermöglichen. Durch die Rekombination entstehen Exzitonen (= Anregungszustände), die ihre Überschussenergie auf die jeweilige elektrolumineszierende Verbindung übertragen. Diese elektrolumineszierende Verbindung kann daraufhin in einen bestimmten elektronischen Anregungszustand übergehen, der dann möglichst vollständig und unter weitgehender Vermeidung strahlungsloser Desaktivierungsprozesse durch Lichtemission in den zugehörigen Grundzustand umgewandelt wird.

Als elektronischer Anregungszustand, der auch durch Energieübertragung von einem geeigneten Vorläufer-Exziton gebildet werden kann, kommt, von wenigen Ausnahmen abgesehen, entweder ein Singulett- oder ein Triplett-Zustand, bestehend aus drei Unterzuständen, in Betracht. Da beide Zustände aufgrund der Spinstatistik in der Regel im Verhältnis 1:3 besetzt werden, ergibt sich, dass bei einer Emission aus dem Singulett-Zustand, die als Fluoreszenz bezeichnet wird nur maximal 25 % der erzeugten Exzitonen wieder zur Emission führen. Dagegen können bei einer Triplett-Emission, die als Phosphoreszenz bezeichnet wird, sämtliche Exzitonen ausgenutzt, umgewandelt und als Licht emittiert werden (Triplett-Harvesting), so dass in diesem Fall die Innere Quantenausbeute den Wert von 100 % erreichen kann, sofern der mit angeregte und energetisch über dem Triplett-Zustand liegende Singulett-Zustand vollständig in den Triplett-Zustand relaxiert (Inter-System-Crossing, ISC) und strahlungslose Konkurrenzprozesse bedeutungslos bleiben. Somit sind Triplett-Emitter nach dem bisherigen Stand der Technik effizientere Elektro-Luminophore und besser geeignet, in einer organischen Leuchtdiode für eine hohe Lichtausbeute zu sorgen.

Bei den für das Triplett-Harvesting geeigneten Triplett-Emittern werden in der Regel Übergangsmetall-Komplexverbindungen eingesetzt, in denen das Metall aus der dritten Periode der Übergangsmetalle gewählt wird. Hierbei handelt es sich vorwiegend um sehr teure Edelmetalle wie Iridium, Platin oder auch Gold (siehe dazu auch H. Yersin, Top. Curr. Chem. 2004, 241, 1 und M. A. Baldo, D. F. O'Brien, M. E. Thompson, S. R. Forrest, Phys. Rev. B 1999, 60, 14422). Der wesentliche Grund dafür liegt in der hohen Spin-Bahn-Kopplung (SBK) der Edelmetall-Zentralionen (SBK-Konstante Ir(III): ≈ 4000 cm⁻¹; Pt(II): ≈ 4500 cm-¹; Au(I): ≈ 5100 cm-¹; Ref.: S. L. Murov, J. Carmicheal, G. L. Hug, Handbook of Photochemistry, 2nd Edition, Marcel Dekker, New York 1993, p. 338 ff). Durch diese quantenmechanische Eigenschaft wird der ohne SBK für optische Übergänge strikt verbotene Triplett-Singulett-Übergang erlaubt und die für die OLED-Anwendung erforderliche kurze Emissionslebensdauer von wenigen µs erreicht.

Es wäre von großem wirtschaftlichen Vorteil, wenn diese teuren Edelmetalle durch preiswerte Metalle ersetzt werden könnten. Darüber hinaus ist eine Vielzahl der bisher bekannten OLED-Emitter-Materialien aus ökologischer Sicht nicht unbedenklich, so dass die Verwendung von weniger toxischen Materialien wünschenswert wäre.

### Beschreibung der Erfindung

Die Erfindung betrifft die Schaffung und Bereitstellung neuer Cu(I)-Verbindungen mit verbesserten Eigenschaften. Insbesondere weisen diese Cu(I)-Verbindungen die folgenden Eigenschaften auf:
- relativ kurze Emissionslebensdauer, insbesondere von nur wenigen µs,
- hohe Emissionsquantenausbeuten,
- weitgehende Verhinderung von unerwünschten Geometrie-Veränderungen und/oder
- Löslichkeit in verschiedenen, den technologischen Anforderungen genügenden Lösungsmitteln.

Zu den organischen Lösungsmitteln im Sinne der Erfindung gehören
- Alkane, auch halogenierte Alkane wie Pentan, Hexan, Heptan, einschließlich verzweigter Alkane,
- Dichlormethan, Chloroform, 1,2-Dichlorethan, 1,1,1-Trichlorethan, Tetrachlorkohlenstoff, Perchlorethylen
- Aromatische Kohlenwasserstoffe, auch halogeniert: Benzol, Toluol, Mesitylen, Chlorbenzol, 1,2-Dichlorbenzol
- Ether: Tetrahydrofuran, Diethylether, Phenetol
- Ketone: Aceton, Methylethylketon, Propiophenon
- sowie: Acetonitril, Nitromethan, Dimethylsulfoxid, Dimethylformamid, Methanol, Ethanol und Essigsäureethylester.

In bevorzugten Ausgestaltungen der Erfindung ist der Kupfer(I)komplex insbesondere in mindestens einem der folgenden Lösungsmittel gut löslich: polaren Kohlenwasserstoffe wie z. B. Dichlormethan, Chloroform, 1,2-Dichlorethan, 1,1,1-Trichlorethan, Perchlorethylen, Toluol, Mesitylen, Chlorbenzol, 1,2-Dichlorbenzol, Tetrahydrofuran, Diethylether, Phenetol, Aceton, Methylethylketon, Propiophenon, Nitromethan, Dimethylsulfoxid, Dimethylformamid, Methanol und Ethanol.

### Stabilisierung der Molekularstruktur

Vierfach koordinierte Cu(I) Komplexe weisen im elektronischen Grundzustand eine annähernd tetraedrische Koordination des Metallatoms auf. Bei Anregung in einen elektronischen angeregten Zustand mit ausgeprägtem Metall-zu-Ligand-Charge-Transfer Charakter und der damit verbundenen formalen Oxidierung des Metallatoms zu Cu(II) kann es zu wesentlichen Veränderungen der Geometrie des Komplexes in Richtung einer quadratisch-planaren Koordination kommen, was daher als "Planarisierung" des Komplex-Moleküls bezeichnet werden kann. Dieser Prozess liefert einen sehr effektiven Mechanismus für das Löschen (Quenchen) der Lumineszenz.

In den erfindungsgemäßen Kupfer(I)komplexen wird dieser Löschmechanismus durch Anwesenheit sterisch anspruchvoller Substituenten am einfach negativ geladenen Ligand N∩L (insbesondere in den ortho-Positionen zu den Koordinationsstellen) verhindert oder sehr reduziert durch eine Verhinderung der Geometrie-Veränderungen um das Cu-Atom. Gleichzeitig tragen derartige Substitutionen zum Schutz des Cu-Zentrums vor unerwünschten chemischen Reaktionen mit nukleophilen Substanzen (Lösungsmitteln, Verunreinigungen, leicht koordinierenden Matrixmaterialien) bei. Bereits eine Methylgruppe führt zu einer merklichen "Versteifung" der resultierenden Cu-Komplexe. Ein sterisch anspruchsvoller Substituent ist daher neben Methyl insbesondere ein Alkylrest -(CH₂)ₙ-CH₃ (n = 0 - 20) (auch verzweigt), ein Arylrest mit 6 - 20 Kohlenstoffatomen (z. B. -Ph), Alkoxyrest -O-(CH₂)ₙ-CH₃ (n = 0 - 20), ein Aryloxyrest (z. B. -OPh) oder ein Silanrest (z. B -SiMe₃). Die Alkyl- und Arylreste können auch substituiert sein (z. B. mit Halogenen, Alkoxy- oder Silan-Gruppen, usw.) oder zu annelierten Ringsystemen führen.

### Chemische Leitstruktur

Der erfindungsgemäße Emitter A umfasst folgende Merkmale: 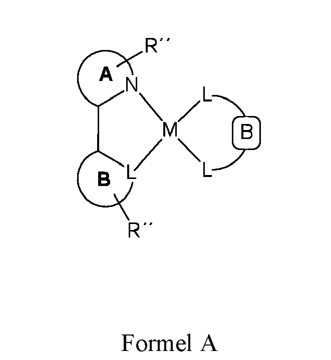 wobei

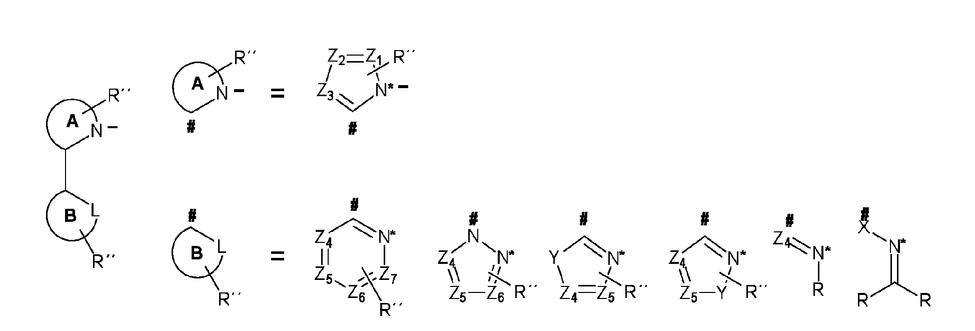

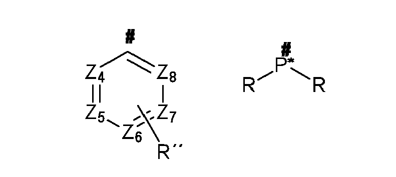

Darin bedeuten:
● M ist Cu(I).
● Bei L-B-L handelt es sich um einen neutralen, zweizähnigen Liganden. Bevorzugt ist L ein Phosphanyl- oder Arsanyl-Rest E*(R1)(R2), mit E = P oder As; R1, R2 können jeweils unabhängig voneinander Wasserstoff, Halogen sein oder Substituenten, die über Sauerstoff- (-OR), Stickstoff- (-NR₂) oder Siliziumatome (-SiR₃) gebunden sind sowie Alkyl- (auch verzweigt oder zyklisch), Aryl-, Heteroaryl-, Alkenyl-, Alkinyl-Gruppen bzw. substituierte Alkyl- (auch verzweigt oder zyklisch), Aryl-, Heteroaryl- und Alkenyl-Gruppen mit Substituenten wie Halogene oder Deuterium, Alkylgruppen (auch verzweigt oder zyklisch), und weitere allgemein bekannte Donor- und Akzeptor-Gruppen, wie beispielsweise Amine, Carboxylate und deren Ester, und CF₃-Gruppen, der über eine Brücke B mit einem weiteren Rest L verbunden ist und damit einen zweizähnigen Liganden bildet, wobei die Brücke B eine Alkylen- oder Arylen-Gruppe oder eine Kombination beider, oder -O-, -NR- oder -SiR₂- ist. Die Gruppen R1-R2 können auch zu anellierten Ringsystemen führen.
● Z1-Z7 besteht aus N oder dem Fragment CR,
   mit R = organischer Rests, der ausgewählt ist aus der Gruppe bestehend aus: Wasserstoff, Halogen oder Gruppen, die über Sauerstoff- (-OR), Stickstoff- (-NR₂), Silizium- (-SiR₃) oder Phosphoratome (-PR₂) gebunden sind sowie Alkyl- (auch verzweigt oder zyklisch), Aryl-, Heteroaryl-, Alkenyl-, Alkinyl-Gruppen bzw. substituierte Alkyl- (auch verzweigt oder zyklisch), Aryl-, Heteroaryl- und Alkenyl-Gruppen mit Substituenten wie Halogene oder Deuterium, Alkylgruppen (auch verzweigt oder zyklisch), und weitere allgemein bekannte Donor- und Akzeptor-Gruppen, wie beispielsweise Amine, Carboxylate und deren Ester, und CF₃-Gruppen.
● X ist entweder CR₂ oder NR
● Y ist entweder O, S oder NR
● Z8 besteht dem Fragment CR',
   mit R' = OR, NR₂ oder PR₂, wobei die Bindung zum Cu-Atom dann über diese Gruppen erfolgt.
● R" ist ein sterisch anspruchsvoller Substituent bevorzugt in ortho-Position zur Koordinationsstelle, der eine Geometrieveränderung in Richtung einer Planarisierung des Komplexes im angeregten Zustand verhindert. Ein sterisch anspruchsvoller Substituent ist insbesondere ein Alkylrest -(CH₂)ₙ-CH₃ (n = 0 - 20) (auch verzweigt), ein Arylrest mit 6 - 20 Kohlenstoffatomen (z. B. -Ph), Alkoxyrest -O-(CH₂)ₙ-CH₃ (n = 0 - 20), ein Aryloxyrest (z. B. -OPh) oder ein Silanrest (z. B -SiMe₃). Die Alkyl- und Arylreste können auch substituiert sein (z. B. mit Halogenen, Alkoxy- oder Silan-Gruppen, usw.) oder zu annelierten Ringsystemen führen. Obwohl in der Formel A zwei Reste R" dargestellt sind, kann ein erfindungsgemäßer Komplex in einer Ausführungsform der Erfindung auch keinen oder nur einen Rest R" aufweisen.
● Zusätzlich kann der Komplex optional eine Funktions-Gruppe (FG) aufweisen. Dabei handelt es sich um einen weiteren Substituenten, der eine zusätzliche Funktion in den Komplex einbringt, den dieser ansonsten nicht aufweisen würde. Die Funktions-Gruppen FG werden entweder direkt oder über geeignete Brücken (siehe unten) an die N∩L -Substituenten angebracht.
   - Dabei kann es sich entweder um eine Gruppe handeln, die Eigenschaften eines Elektronenleiters besitzt.
   - Es kann sich um eine Gruppe handeln, die Eigenschaften eines Lochleiters aufweist.
   - Es kann sich um einen Gruppe handeln, die die Löslichkeit des Komplexes bestimmt.
● "*" kennzeichnet das Atom, das die Komplexbindung eingeht.
● "#" kennzeichnet das Atom, das mit der zweiten Einheit verbunden ist.

### Definition des N∩L Liganden

Bei dem einfach negativ geladenen Liganden N∩L handelt es sich bevorzugt um einen der nachfolgend dargestellten Moleküle:

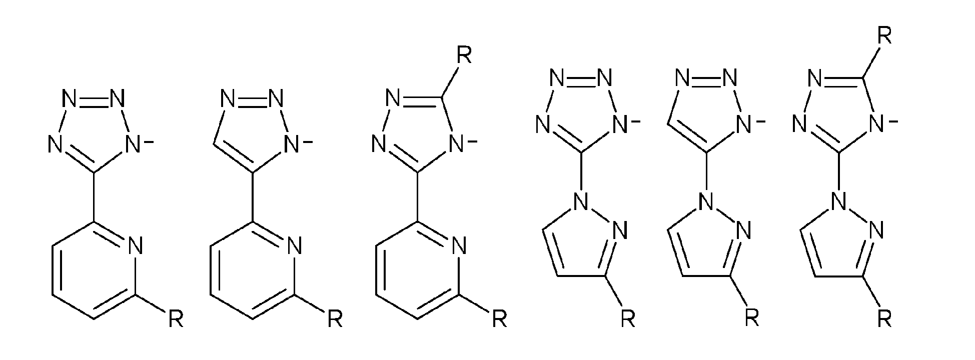

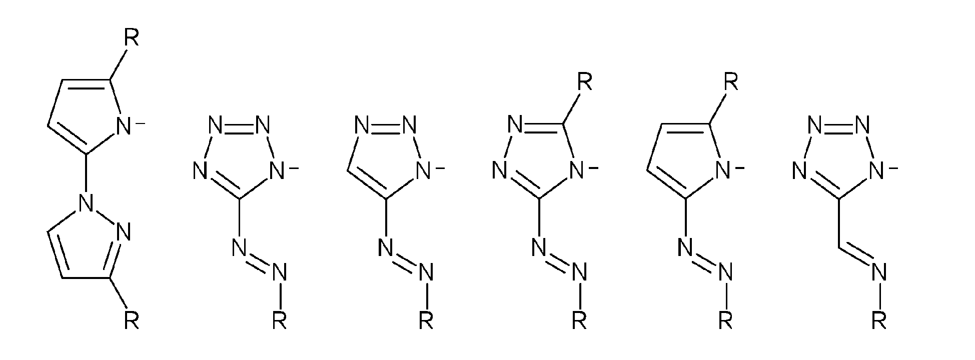

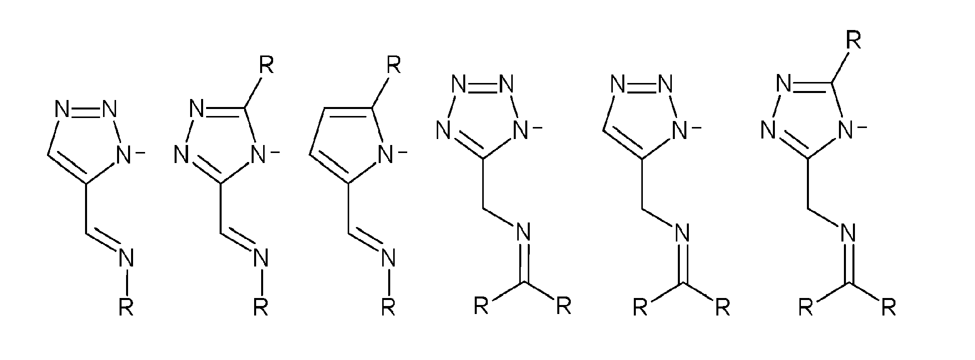

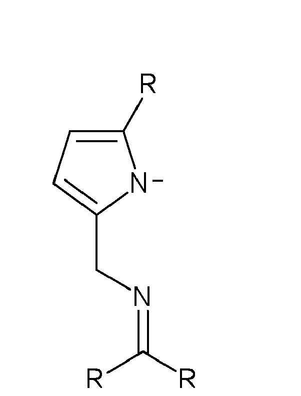

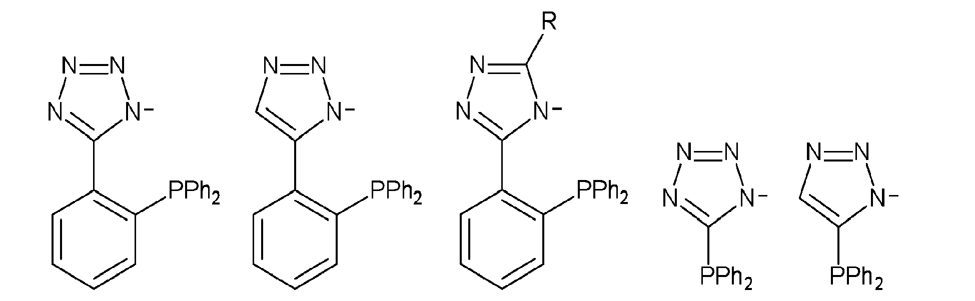

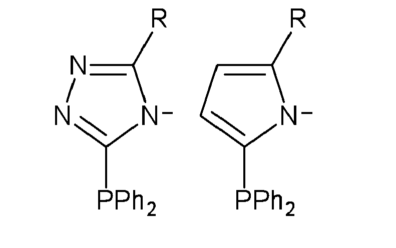

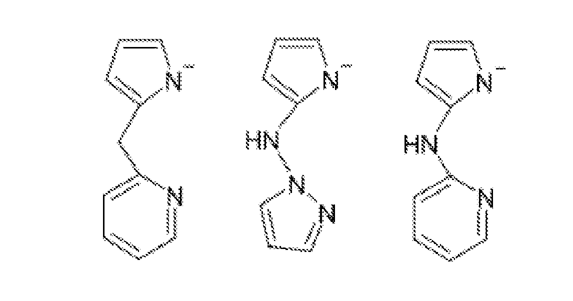

Bei den Substituenten R kann es sich es sich um ein Alkyl-Rest [CH₃-(CH₂)ₙ-] (n = 1 - 20), der auch verzweigt oder mit Halogenen (F, Cl, Br, I) substituiert sein kann oder um einen Aryl-Rest (insbesondere Phenyl) handeln, der mit Alkyl-Gruppen, Halogenen (F, Cl, Br, I), Silan- (-SiR'₃) oder Ethergruppen -OR' (R' definiert wie R) substituiert sein kann. Ebenso kann es sich bei R um ungesättigte Gruppen wie Alkenyl- und Alkinyl-Gruppen handeln, die wiederum mit Alkyl-Gruppen, Halogenen (F, Cl, Br, I), Silan- (-SiR''₃) oder Ethergruppen - OR" (R" definiert wie R) substituiert sein können. Bei R kann es sich aber auch um ein Wasserstoffatom handeln. In einer bevorzugten Ausführungsform der Erfindung entspricht der Substituent R des N∩L Liganden dem sterisch anspruchsvollen Substituenten R" der Formel A.

Der N∩L Ligand kann an geeigneten Stellen mit mindestens einer Funktions-Gruppe FG substituiert sein. So können sich direkte C_{FG}-C_{NN} Bindungen bilden, wobei C_{NN} ein C-Atom des N∩L Liganden darstellt und C_{FG} ein C-Atom der Funktions-Gruppe. Ist das anbindende Atom ein Stickstoffatom, so ergeben sich N_{FG}-C_{NN} Bindungen, wobei N_{FG} für das Stickstoffatom steht. Andererseits kann die Funktions-Gruppe über eine Brücke an den N∩L Liganden angeknüpft werden, wobei sich z. B. Ether-, Thioether-, Ester-, Amid-, Methylen-, Silan-, Ethylen-, Ethin-Brücken anbieten. Damit können sich als Brücken beispielsweise folgende Funktionen ergeben: C_{FG}-O-C_{NN}, C_{FG}-S-C_{NN}, -C_{FG}-C(O)-O-C_{NN}-, C_{FG}-C(O)-NH-C_{NN}-, C_{FG}-CH₂-C_{NN}, C_{FG}-SiR'₂-C_{NN}, C_{FG}-CH=CH-C_{NN}, C_{FG}-C≡C-C_{NN}, N_{FG}-CH₂-C_{NN}.

Die Verfahren zur Verknüpfung der Funktionsgruppe an den N∩L Ligand, entweder direkt oder über eine Brücke, sind dem Fachmann bekannt (Suzuki-, Still-, Heck-, Sonogashira-, Kumuda-, Ullmann-, Buchwald-Hartwig-Kupplung sowie deren Varianten; (Thio)Veretherung, Veresterung, nucleophile und elektrophile Substitutionen am sp³-Kohlenstoff oder Aromaten, usw.). Beispielsweise illustriert der in der Literatur beschriebene Ligand (4,4'-Bis(5-(hexylthio)-2,2'-bithien-5'-yl)-2,2'-bipyridine) die Möglichkeit einer Anbindung eines elektronenleitenden Substituenten an einen bpy Liganden mittels einer Stille Kupplung (C.-Y. Chen, M. Wang, J.-Y. Li, N. Pootrakulchote, L. Alibabaei, C.-h. Ngoc-le, J.-D. Decoppet, J.-H. Tsai, C. Grätzel, C.-G. Wu, S. M. Zakeeruddin, M. Grätzel, ACS Nano 2009, 3, 3103).

Eine weitere Möglichkeit zur Synthese substituierter N∩L Liganden besteht in der Kupplung zweier, bereits mit dem Rest R sowie der Funktions-Gruppe FG substituierter N- und L-Ringe. Die sich hieraus ergebende N∩L-Liganden können daher auch asymmetrisch substituiert sein. Die Verfahren und relevante Literatur sind im Übersichtsartikel von G. Chelucci (G. Chelucci, R. P. Thummel, Chem. Rev. 2002, 102, 3129) zusammengefasst.

In einer besonderen Ausführungsform kann der Rest R auch ein elektronenleitender, lochleitender oder die Löslichkeit erhöhender Substituent sein.

### Definition des L-B-L Liganden

Bei dem neutralen L-B-L-Liganden kann es sich um eines der unten dargestellten Moleküle handeln:

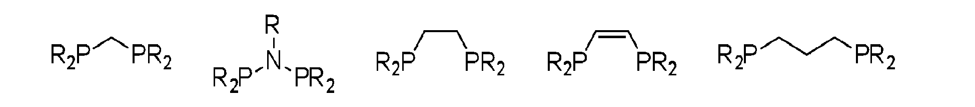

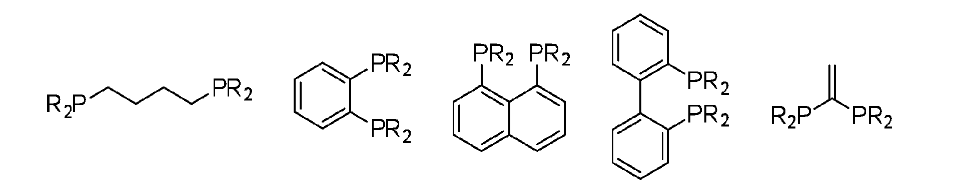

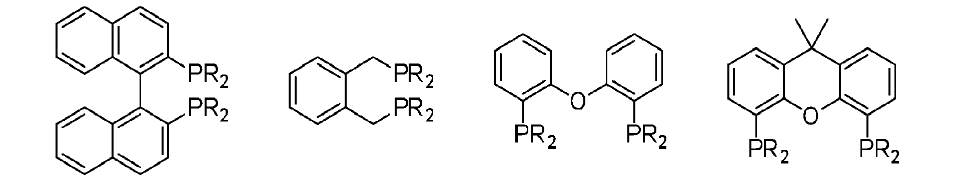

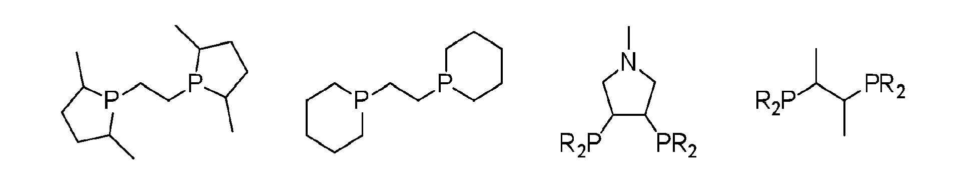

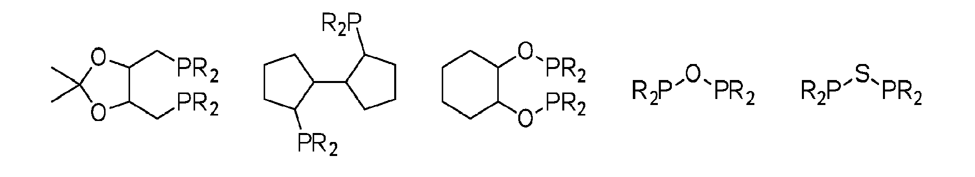

Bei den Substituenten R handelt es sich um einen Alkyl-Rest [CH₃-(CH₂)ₙ-] (n = 0 - 20), der auch verzweigt oder mit Halogenen (F, Cl, Br, I) substituiert sein kann, oder um einen Aryl-Rest (insbesondere Phenyl), der mit Alkyl-Gruppen, Halogenen (F, Cl, Br, I), Silan- (-SiR'₃) oder Ethergruppen -OR' (R' definiert wie R) substituiert sein kann. Ebenso kann es sich bei R um ungesättigte Gruppen wie Alkenyl- und Alkinyl-Gruppen handeln, die wiederum mit Alkyl-Gruppen, Halogenen (F, Cl, Br, I), Silan- (-SiR''₃) oder Ethergruppen -OR" (R" definiert wie R) substituiert sein können.

### Definition der Funktions-Gruppen FG:

Die Funktions-Gruppen (FG) können entweder einfach oder mehrfach am N∩L Liganden gebunden sein. Es können identische oder unterschiedliche Funktions-Gruppen verwendet werden. Die Funktions-Gruppen können auch symmetrisch oder unsymmetrisch vorhanden sein. Meist ist aus synthetischen Gründen eine Zweifachsubstitution identischer Funktions-Gruppen vorteilhaft.

### Elektronenleiter

Da es sich bei den Elektronenleiter-Materialien ausschließlich um aromatische Verbindungen handelt, ist eine Substitution mithilfe einer der gängigen Kupplungsreaktionen möglich. Als Kupplungsreaktionen kommen z. B. die Suzuki-, Still-, Heck-, Sonogashira-, Kumuda-, Ullmann-, Buchwald-Hartwig-Kupplung sowie deren Varianten zu Einsatz.

Dabei geht man von einem mit Halogenid (Cl, Br, I), insbesondere Br, substituierten phen oder bpy-Derivat aus und setzt es mit dem entsprechenden, mit einer geeigneten Abgangsgruppe substituierten Elektronenleiter-Material um. Vorteilhaft ist die Durchführung einer Suzuki-Kupplung unter Verwendung der entsprechenden Arylboronsäuren und -estern, sowie die Buchwald-Hartwig-Kupplung für die Knüpfung von Aryl-N-Bindungen. Abhängig von den Funktions-Gruppen können auch weitere, gängige Verknüpfungsreaktionen angewandt werden, z. B. über eine Brücke zwischen Funktions-Gruppe FG und N∩L-Ligand. Bei Anwesenheit von -OH Gruppen kommen hier z. B. Veresterungen und Etherbildung in Frage, bei -NH₂ Gruppen Imin- und Amidbildung, bei -COOH Gruppen Esterbildung. Entsprechend muss das Subsitutionsmuster des N∩L angepasst werden (siehe oben unter Punkt "N∩L -Ligand"). Die entsprechenden Verfahren zur Anbringung der Funktions-Gruppen FG sind dem Fachmann bekannt.

Als Elektronentransport-Substituenten können beispielsweise folgende Gruppen verwendet werden (Verknüpfung findet an der mit # gekennzeichneten Stelle statt):

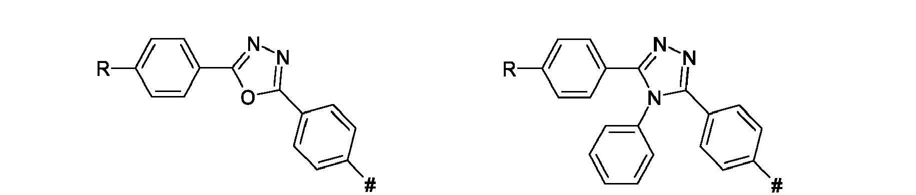

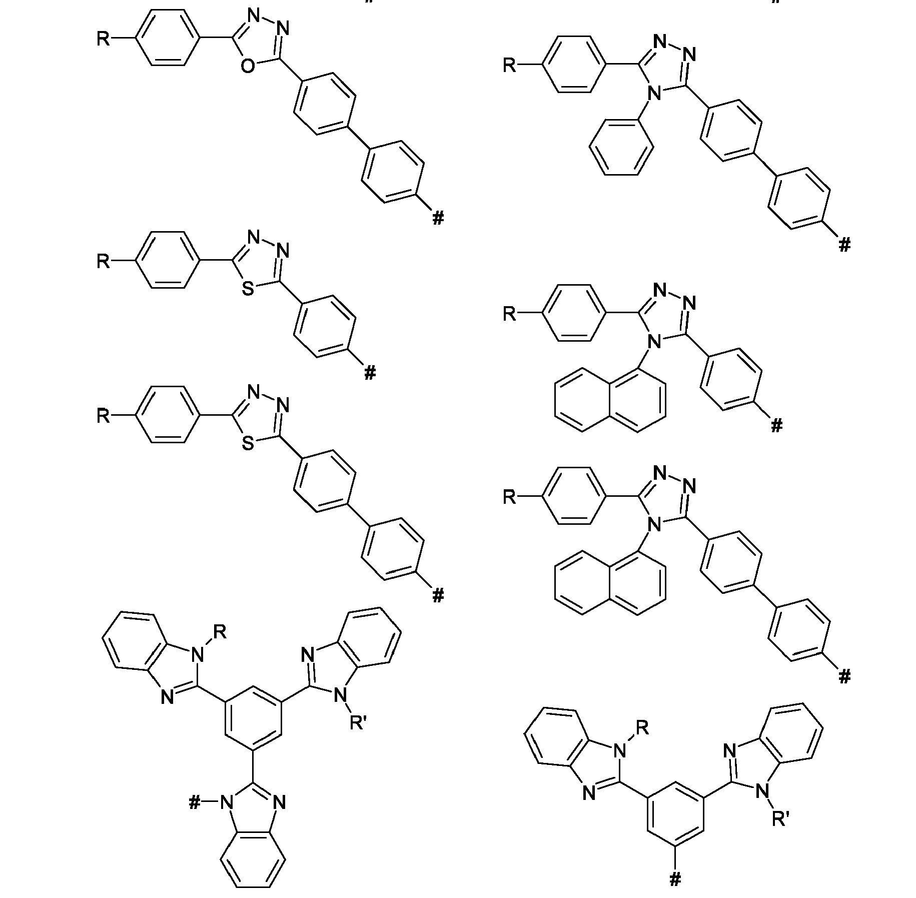

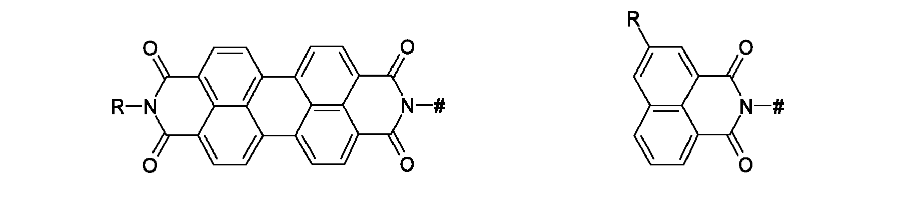

Bei den Substituenten R und R' handelt es sich um einen Alkyl-Rest [CH₃-(CH₂)ₙ-] (n = 0 - 20), der auch verzweigt oder mit Halogenen (F, Cl, Br, I) substituiert sein kann, oder um einen Aryl-Rest (insbesondere Phenyl), der mit Alkyl-Gruppen, Halogenen (F, Cl, Br, I), Silan- (-SiR'''₃) oder Ethergruppen -OR''' (R''' definiert wie R; die hier verwendeten Substituenten entsprechen nicht notwendiger Weise den Substituenten R, R', R" der Formel A) substituiert sein kann. Ebenso kann es sich bei R um ungesättigte Gruppen wie Alkenyl- und Alkinyl-Gruppen handeln, die wiederum mit Alkyl-Gruppen, Halogenen (F, Cl, Br, I), Silan- (-SiR''₃) oder Ethergruppen -OR'' (R" definiert wie R) substituiert sein können.

### Lochleiter

Für den Lochleiter gelten analog die gleichen Aussagen wie für die Elektronenleiter. Auch hier wird die Verknüpfung des Lochleiters an den N∩L -Liganden am einfachsten durch Palladium katalysierte Kupplungsreaktionen verwirklicht; weitere Verknüpfungen, auch über eine Brücke, sind ebenfalls möglich.

Als Lochtransport-Substituenten können beispielsweise folgende Gruppen verwendet werden (Verknüpfung findet an der mit # gekennzeichneten Stelle statt):

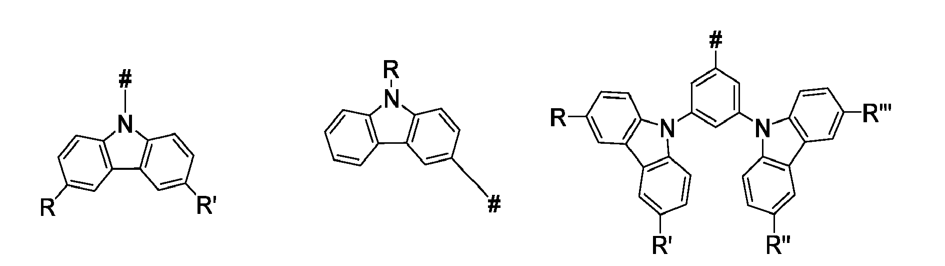

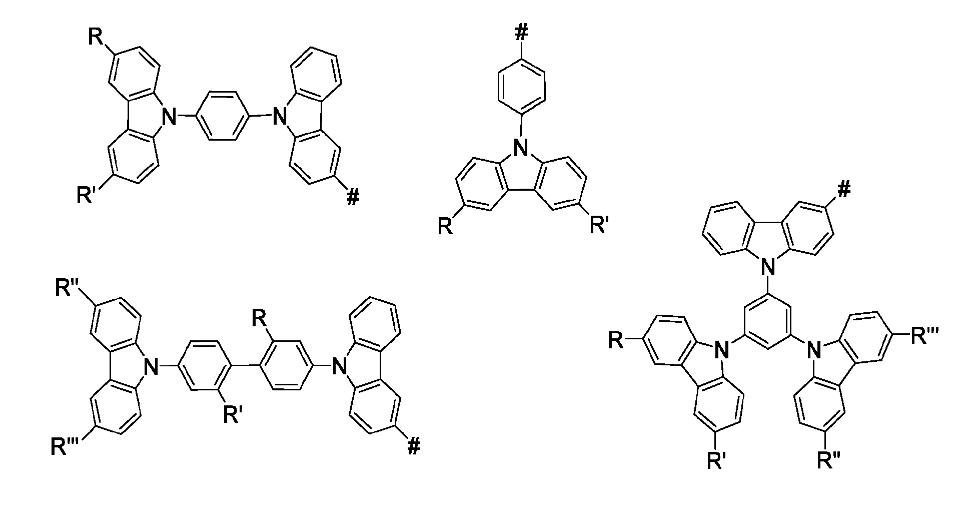

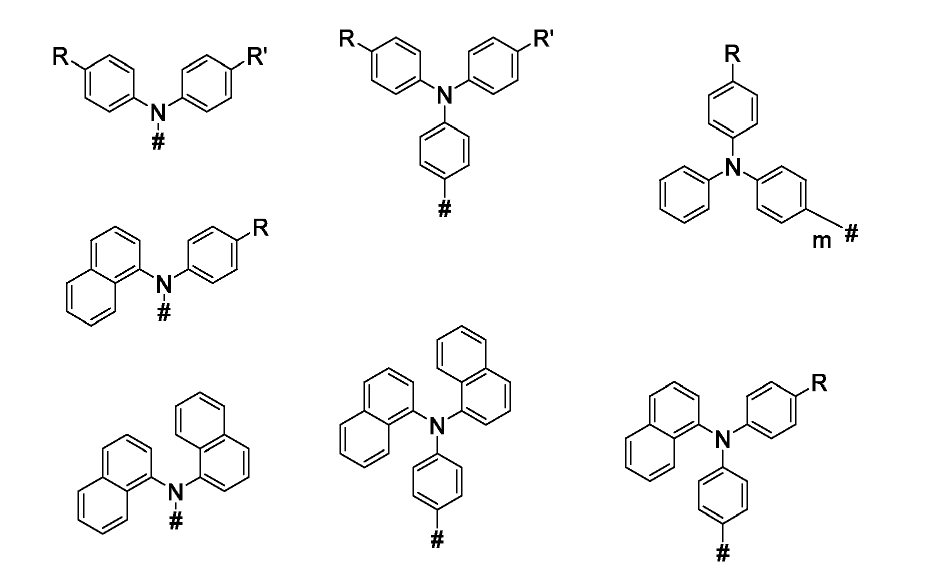

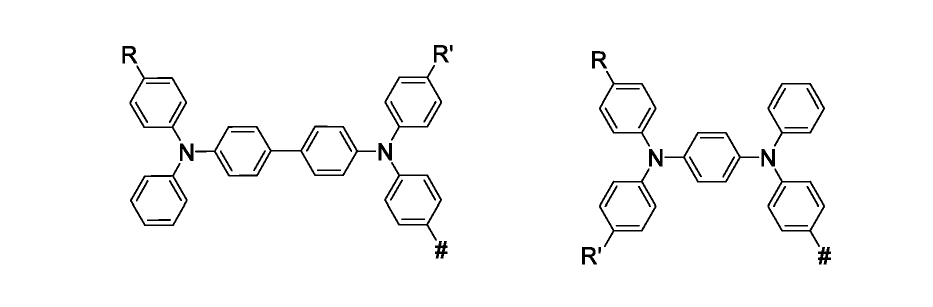

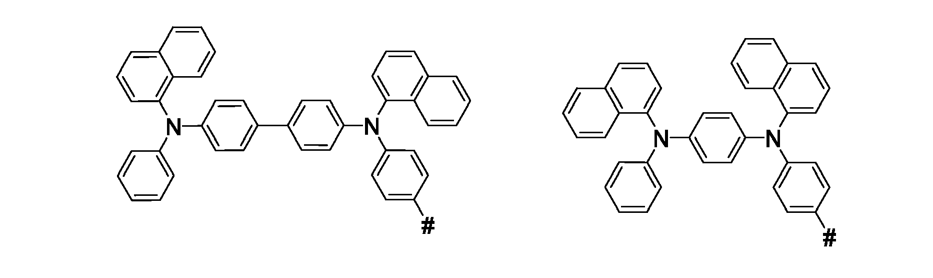

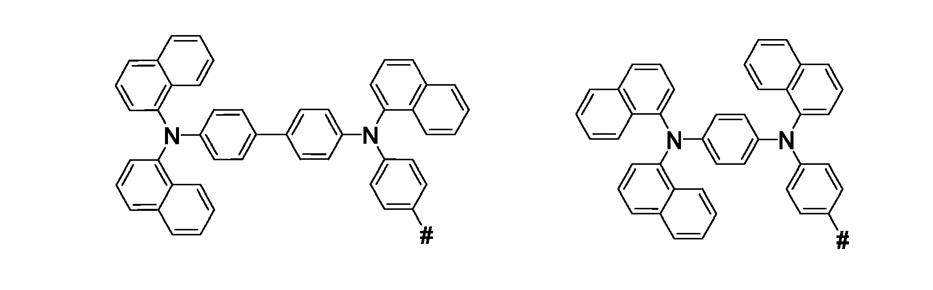

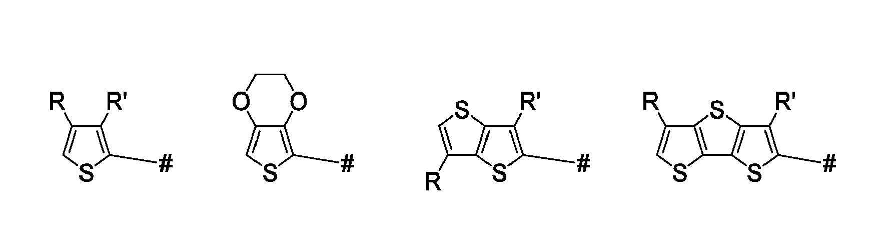

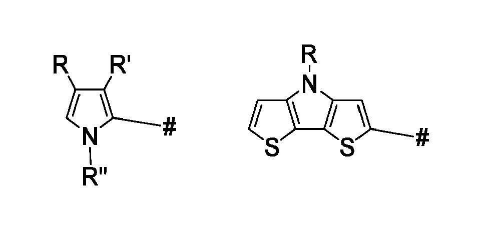

Bei den Substituenten R, R" und R"' handelt es sich um einen Alkyl-Rest [CH₃-(CH₂)ₙ-] (n = 0 - 20), der auch verzweigt oder mit Halogenen (F, Cl, Br, I) substituiert sein kann, oder um einen Aryl-Rest (insbesondere Phenyl), der mit Alkyl-Gruppen, Halogenen (F, Cl, Br, I), Silan- (-SiR''''₃) oder Ethergruppen -OR'''' (R"" definiert wie R; die hier verwendeten Substituenten entsprechen nicht notwendiger Weise den Substituenten R, R', R" der Formel A) substituiert sein kann. Ebenso kann es sich bei R um ungesättigte Gruppen wie Alkenyl- und Alkinyl-Gruppen handeln, die wiederum mit Alkyl-Gruppen, Halogenen (F, Cl, Br, I), Silan- (-SiR''₃) oder Ethergruppen -OR'' (R" definiert wie R) substituiert sein können.

### Löslichkeit

Bei einer Herstellung von opto-elektronischen Bauteilen mittels nass-chemischer Prozesse ist es vorteilhaft, die Löslichkeit gezielt einzustellen. Hierdurch kann das Auf- bzw. Anlösen einer bereits aufgebrachten Schicht vermieden werden. Durch das Einbringen spezieller Substituenten können die Löslichkeitseigenschaften stark beeinflusst werden. Dadurch ist es möglich, orthogonale Lösungsmittel zu verwenden, die jeweils nur die Substanzen des aktuellen Verarbeitungsschrittes lösen, aber nicht die Substanzen der darunter liegenden Schicht(en):

### Löslichkeit in unpolaren Medien

Unpolare Funktions-Gruppen FG erhöhen die Löslichkeit in unpolaren Lösungsmitteln und erniedrigen die Löslichkeit in polaren Lösungsmitteln. Unpolare Gruppen sind z. B. Alkylgruppen [CH₃-(CH₂)ₙ-] (n = 1 - 30), auch verzweigte, substituierte Alkylgruppen, z. B. mit Halogenen. Hierbei sind besonders hervorzuheben: teil- oder perfluorierte Alkylgruppen sowie perfluorierte Oligo- und Polyether, z. B. [-(CF₂)₂-O]ₙ- und (-CF₂-O)ₙ- (n = 2 - 500). Weitere unpolare Gruppen sind: Ether -OR, Thioether -SR, unterschiedlich substituierte Silane R₃Si- (R = Alkyl oder Aryl), Siloxane R₃Si-O-, Oligosiloxane R'(-R₂Si-O)ₙ- (R' = R, n = 2 - 20), Polysiloxane R'(-R₂Si-O)ₙ- (n > 20); Oligo/polyphosphazene R'(-R₂P=N-)ₙ- (n = 1 - 200).

### Löslichkeit in polaren Medien

Polare Funktionsgruppen erhöhen die Löslichkeit in polaren Medien. Diese können sein:
● Alkohol-Gruppen: -OH
● Thioalkohole -SH
● Carbonsäure-, Phosphonsäure-, Sulfonsäure-Reste sowie deren Salze und Ester (R = H, Alkyl, Aryl, Halogen; Kationen: Alkalimetalle, Ammonium-Salze): -COOH, -P(O)(OH)₂, -P(S)(OH)₂, -S(O)(OH)₂, -COOR, -P(O)(OR)₂, -P(S)(OR)₂, -S(O)(OR)₂, -CONHR, -P(O)(NR₂)₂, -P(S)(NR₂)₂, -S(O)(NR₂)₂
● Sulfoxide: -S(O)R, -S(O)₂R
● Carbonylgruppen: -C(O)R
● Amine: -NH₂, -NR₂, -N(CH₂CH₂OH)₂,
● Hydroxylamine =NOR
● Oligoester, -O(CH₂O-)ₙ, -O(CH₂CH₂O-)ₙ (n = 2 - 200)
● Positiv geladene Substituenten: z. B. Ammonium-Salze -N⁺R₃X⁻, Phosphonium-Salze -P⁺R₃X⁻
● Negativ geladene Substituenten, z. B. Borate -(BR₃)⁻, Aluminate -(AlR₃)⁻ (als Anion kann ein Alkalimetal oder Ammoniumion fungieren).

Um die Anwesenheit frei beweglicher Ionen zu vermeiden, können auch positiv und negativ geladene Substituenten in einer Funktions-Gruppe FG vereinigt werden.

Demgemäß betrifft die Erfindung in einem weiteren Aspekt ein Verfahren zur Herstellung einer opto-elektronischen Vorrichtung, insbesondere wobei die Herstellung nass-chemisch erfolgt und das Verfahren die folgenden Schritte aufweist:

Aufbringung eines in einem ersten Lösungsmittel gelösten ersten Emitterkomplexes auf einen Träger, und Aufbringung eines in einem zweiten Lösungsmittel gelösten zweiten Emitterkomplexes auf den Träger;
wobei der erste Emitterkomplexes nicht in dem zweiten Lösungsmittel löslich ist und der zweite Emitterkomplexes nicht in dem ersten Lösungsmittel löslich ist; und wobei der erste Emitterkomplex und/oder der zweite Emitterkomplex ein erfindungsgemäßer Kupfer(I)komplex ist. Das Verfahren kann weiterhin den folgenden Schritt aufweisen: Aufbringung eines in dem ersten Lösungsmittel oder in einem dritten Lösungsmittel gelösten dritten Emitterkomplexes auf den Träger, wobei der dritte Kupfer(I)komplex ein erfindungsgemäßer Kupfer(I)komplex ist. Erstes und zweites Lösungsmittel sind dabei nicht identisch.

In einer bevorzugten Ausführungsform ist die opto-elektronische Vorrichtung eine Weißlicht-OLED, wobei der erste Emitterkomplexe ein Rotlichtemitter ist, der zweite Emitterkomplex ein Grünlichtemitter ist und der dritte Emitterkomplex ein Blaulichtemitter ist.

### Figuren

**Figur 1****:** Prinzipieller Aufbau eines OLEDs. Die Abbildung ist nicht maßstabsgerecht gezeichnet.

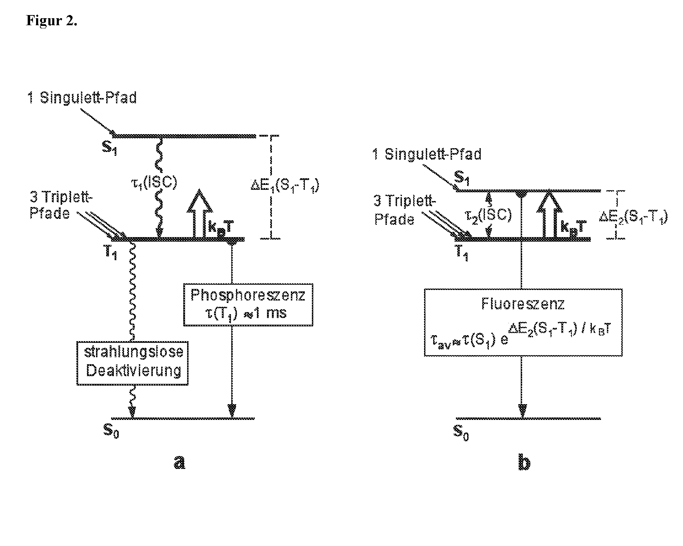

**Figur 2****:** Erläuterungen des Elektro-Lumineszenz-Verhaltens **a** für ÜbergangsmetallKomplexe mit kleiner oder sich nur in geringem Maße auswirkender Spin-Bahn-Kopplung (z. B. Metall-Komplexe der ersten Periode der Übergangsmetalle) und **b** für erfindungsgemäß selektierte Cu(I)-Komplexe. Der in **a** für τ(T₁) angegebene Wert repräsentiert ein Beispiel.

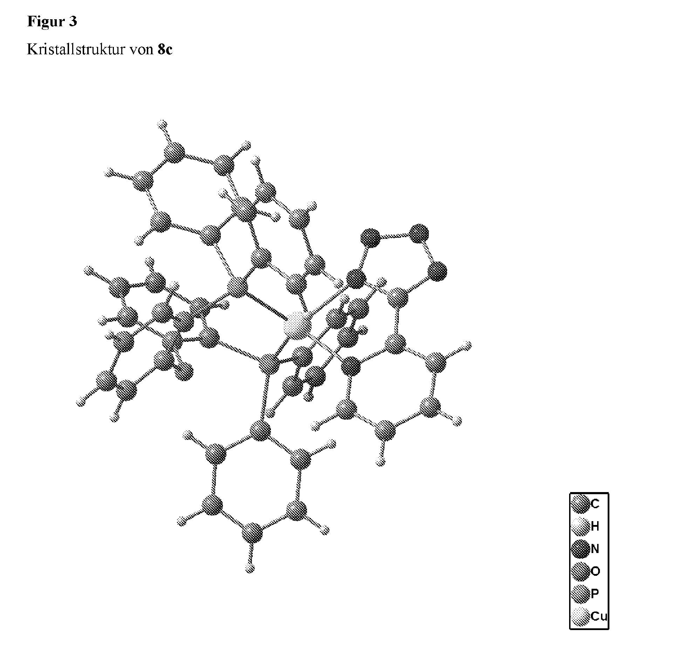

**Figur 3****:** ORTEP Bild eines Cu(N∩L)(L-B-L)-Komplexes.

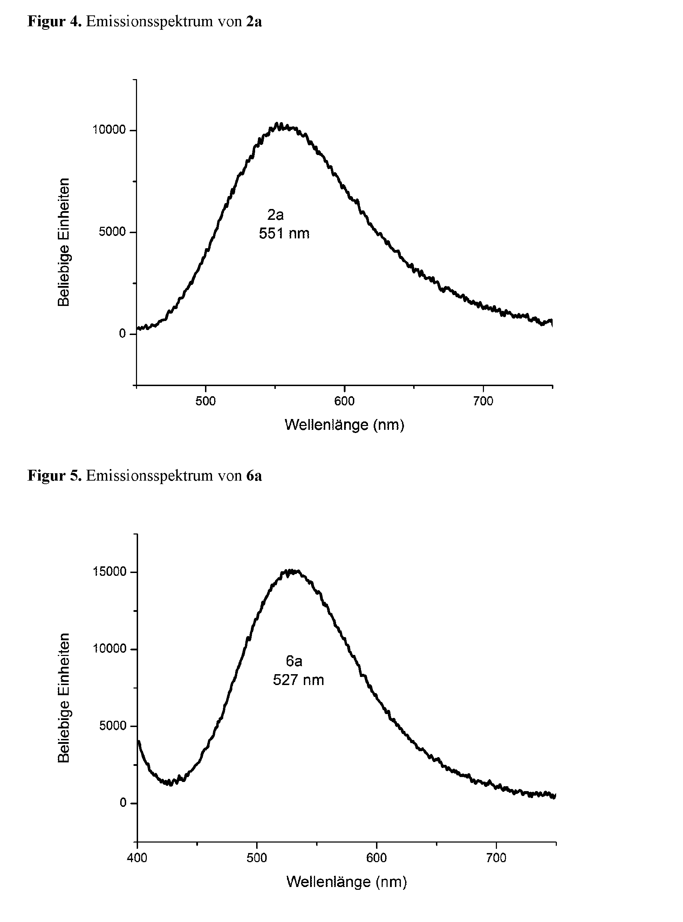

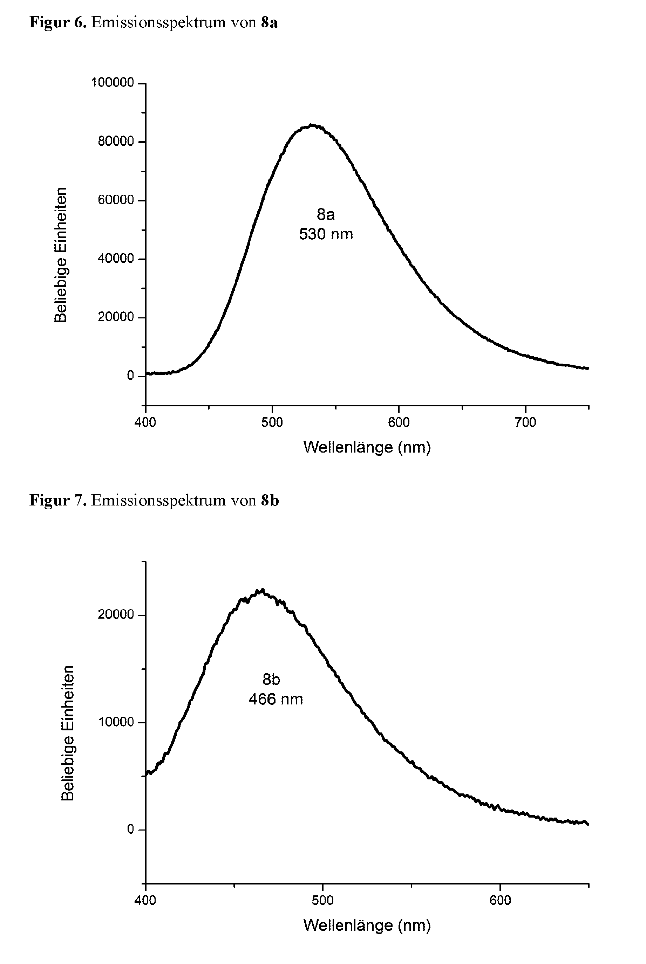

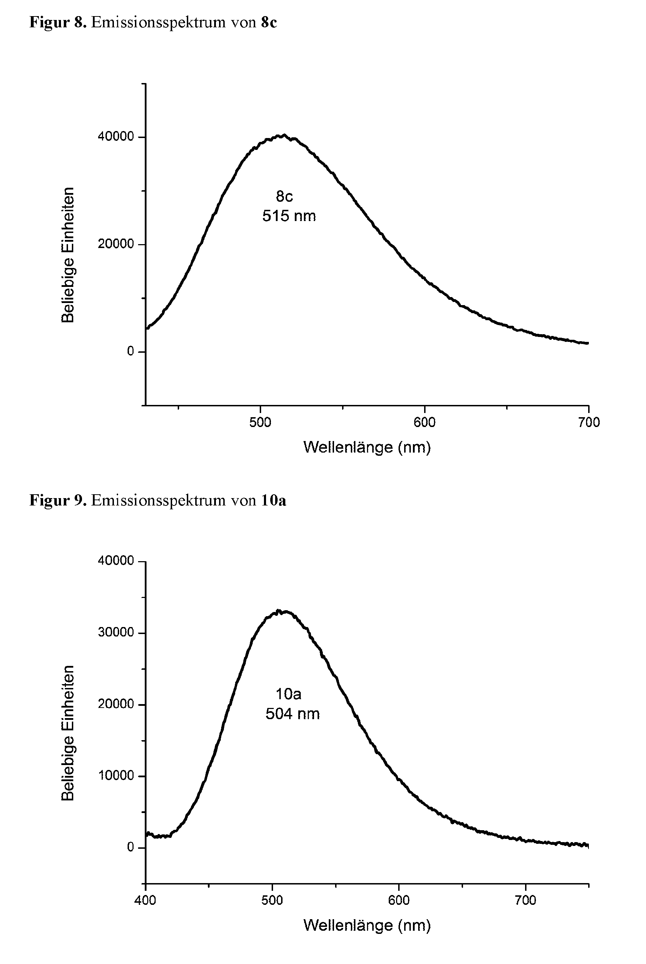

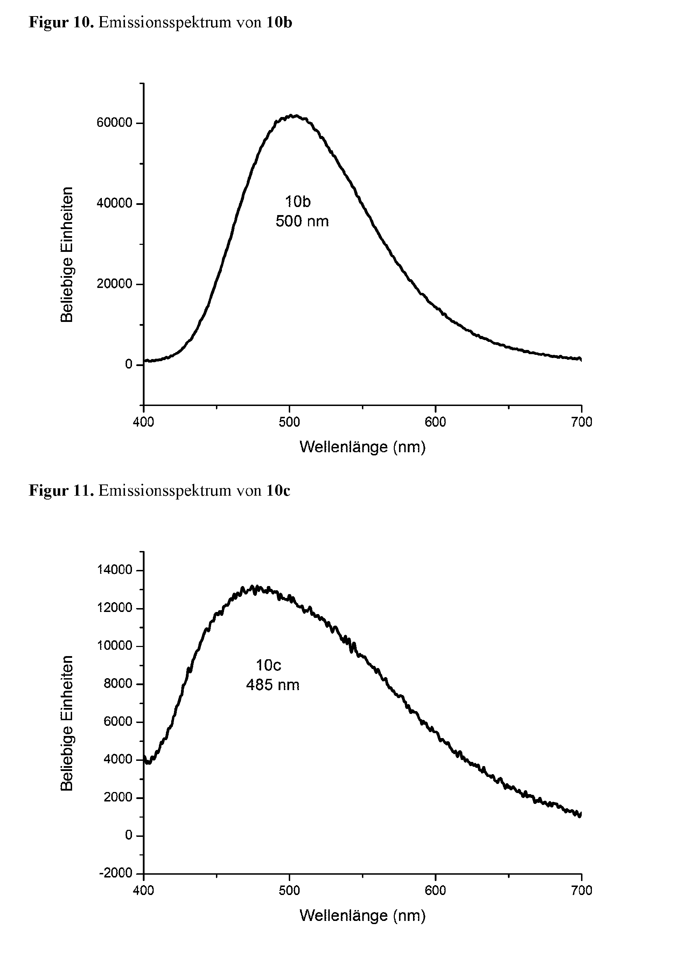

**Figuren 4 bis 11****:** Emissionsspektren verschiedener Cu(N∩L)(L-B-L)-Komplexe.

### Beispiele

### Synthese der Cu(I)-Komplexe:

Unter Verwendung der oben dargestellten Liganden werden die entsprechenden neutralen Cu(N∩L)(L-B-L)-Komplexe hergestellt:

### Beispiel 1

Unter Stickstoff wurde der N∩L-Ligand (1.00 mmol, 1.00 Äquiv.) in 5 mL THF gelöst und bei 0 °C mit n-Buthyllithium (2.5 M in Hexan, 0.40 mL, 1.00 mmol, 1.00 Äquiv.) deprotoniert. Es wurde 30 min bei Raumtemperatur gerührt. Eine zweite Lösung aus Kupfer(I)salz (1.00 mmol, 1.00 Äquiv.) und neutralem L-B-L-Ligand (1.00 mmol, 1.00 Äquiv.) in 5 mL THF wurde unter Stickstoff 30 min gerührt. Dann wurden beide Lösungen zusammengeben und 4 h gerührt. Der Komplex wurde durch Ausfällen in Diethylether gereinigt, abfiltriert und mit Diethylether gewaschen.

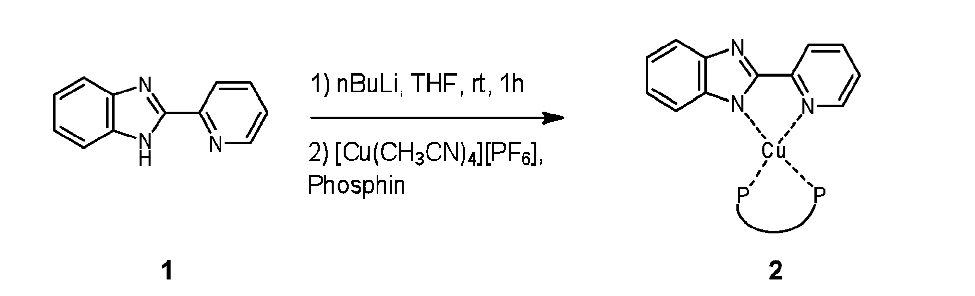

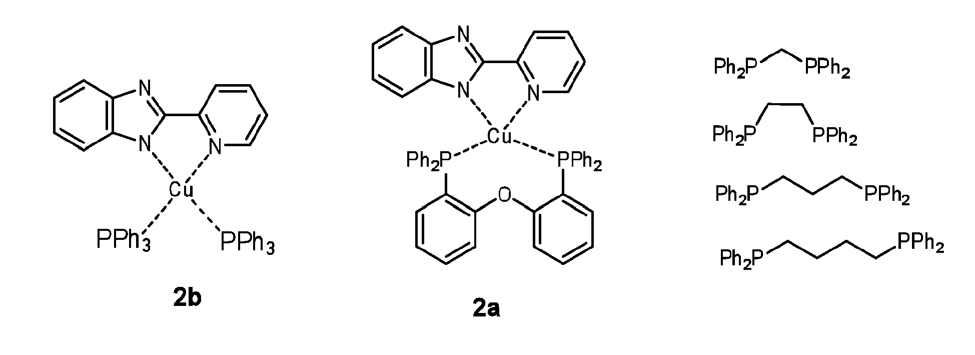

### Beispiel 2

Die Synthese erfolgte analog der in Beispiel 1 genannten.

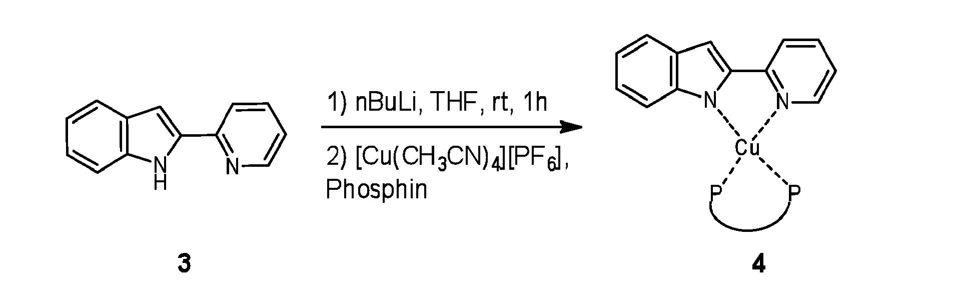

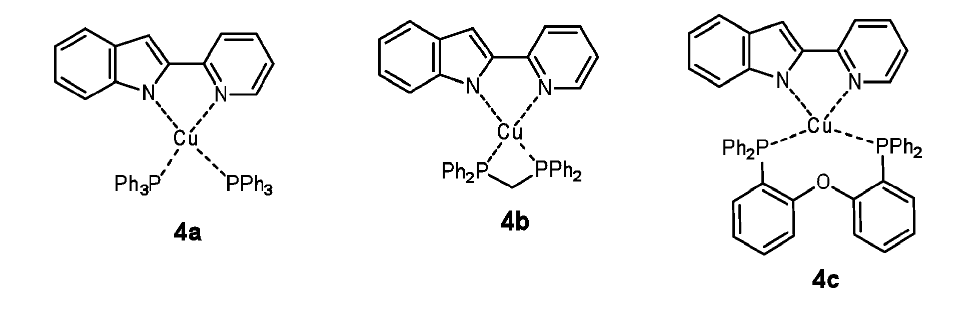

### Beispiel 3

Die Synthese erfolgte analog der in Beispiel 1 genannten.

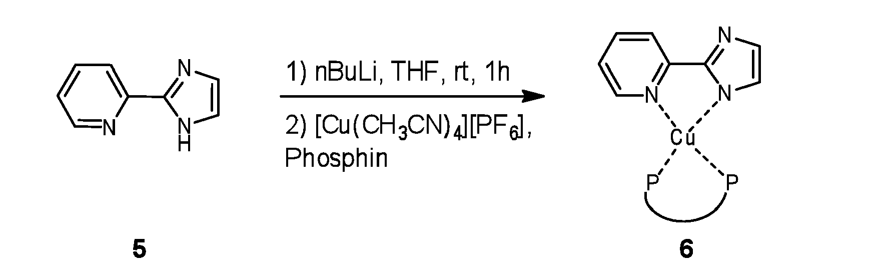

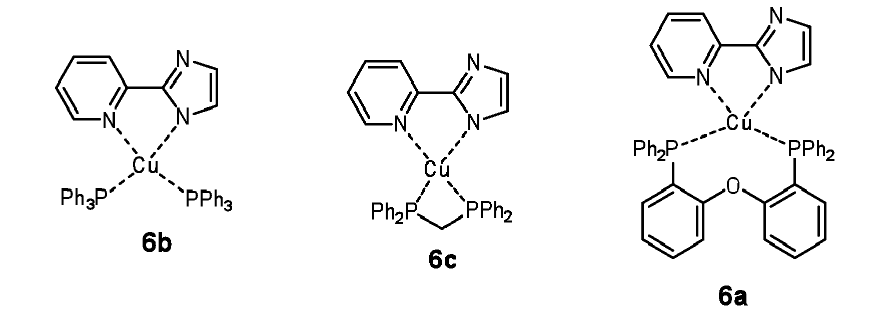

### Beispiel 4

Unter Stickstoff wurden der entsprechende N∩L-Ligand (1.00 mmol, 1.00 Äquiv.), [Cu(CH₃CN)₄]PF₆ **(10)** (1.00 mmol, 1.00 Äquiv.) und der L-B-L-Ligand (1.00 mmol, 1.00 Äquiv.) in 10 mL Lösungsmittelgemisch aus Dichlormethan:Ethanol = 3:1 unter Stickstoff gelöst und 4 h gerührt. Der Komplex wurde durch Ausfällen in Diethylether gereinigt, abfiltriert, mit Diethylether gewaschen und getrocknet.

Unter Stickstoff wurden der oben erhaltene Komplex (0.05 mmol, 1.00 Äquiv.) und KOH (7.75 mmol, 15.0 Äquiv.) in 5 mL Methanol unter Stickstoff gelöst und 6 h gerührt. Anschließend wurde das Lösungsmittel im Vakuum entfernt, der Rückstand mit DCM extrahiert und filtriert. Nach Entfernen des Lösungsmittels wurde der Komplex als Pulver erhalten.

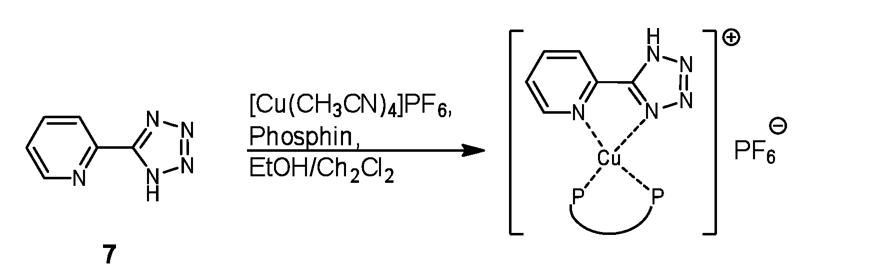

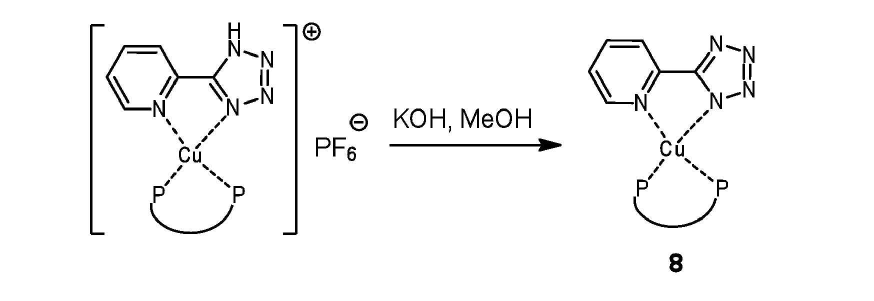

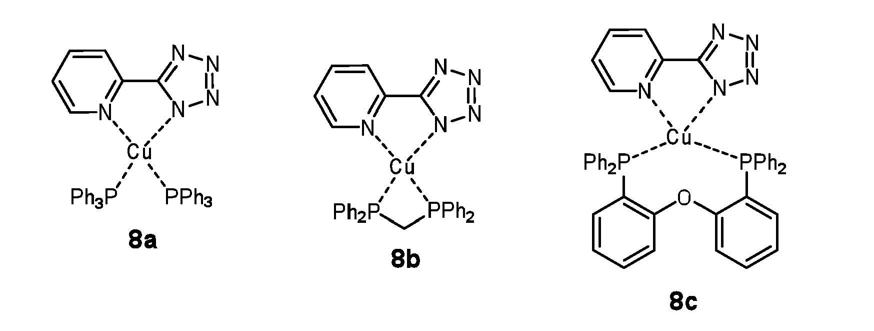

### Beispiel 5

Unter Stickstoffatmosphäre wurde der N∩L-Ligand (1.00 mmol, 1.00 Äquiv.) mit einer äquimolaren Menge an Cu(CH₃CN)₄]PF₆ und dem L-B-L-Ligand (1.00 mmol, 1.00 Äquiv.) in 10 mL Lösungsmittelgemisch aus Dichlormethan:Ethanol = 3:1 unter Stickstoff gelöst und kurz rühren gelassen. Dann wurde eine äquimolare Menge an KOH zugeben. Das Produkt fiel aus und wurde abfiltriert. Nach dem Waschen mit Wasser, kaltem Acetonitril und Diethylether wurde das Produkt im Vakuum getrocknet.

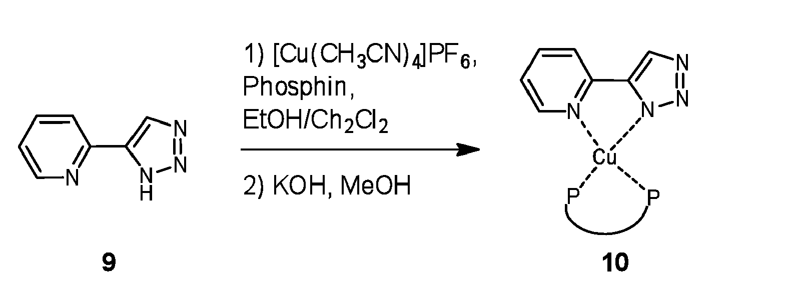

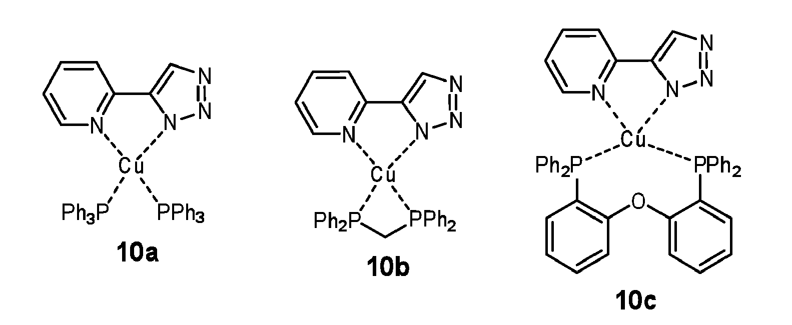

### Beispiel 6

Unter Stickstoffatmosphäre wurde der N∩L-Ligand (1.00 mmol, 1.00 Äquiv.) mit einer äquimolaren Menge an Cu(CH₃CN)₄]PF₆, dem L-B-L-Ligand (1.00 mmol, 1.00 Äquiv.) und KOH in 10 mL Lösungsmittelgemisch aus Dichlormethan:Ethanol = 3:1 gelöst. Nach einiger Zeit fiel das Produkt aus und wurde abfiltriert. Nach dem Waschen mit Wasser, kaltem Acetonitril und Diethylether wurde das Produkt im Vakuum getrocknet.

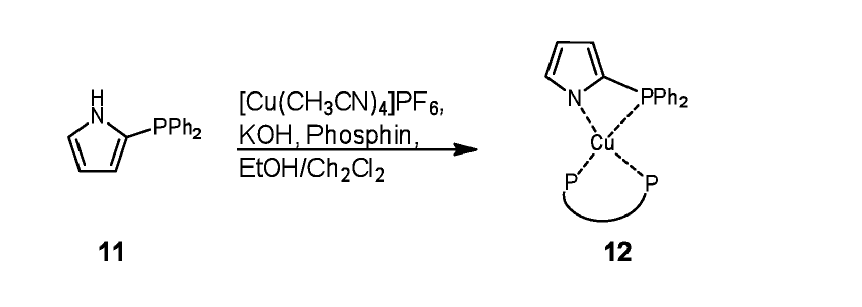

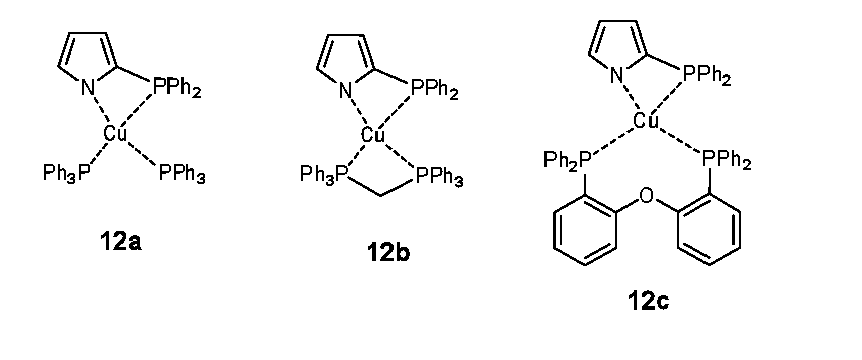

### Beispiel 7

Die Synthese erfolgte analog der in Beispiel 1 genannten.

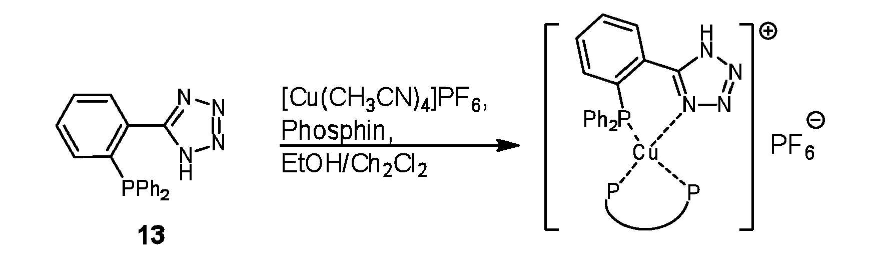

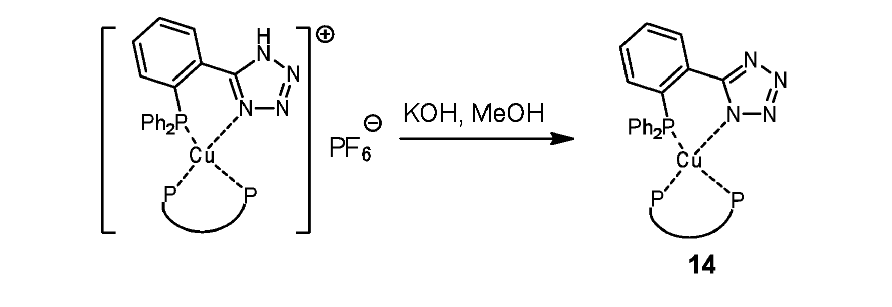

### Beispiel 8

Die Synthese erfolgte analog der in Beispiel 1 genannten.

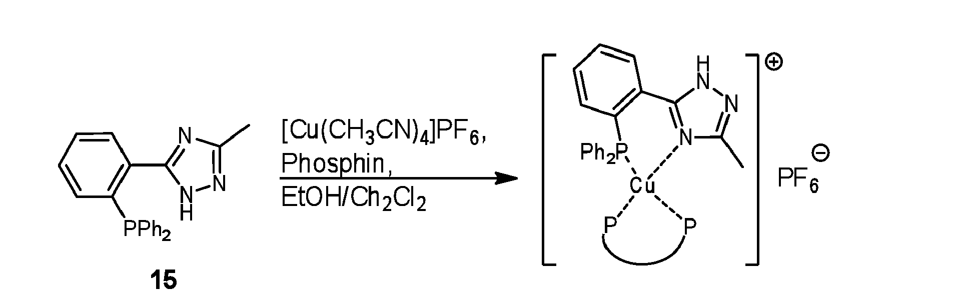

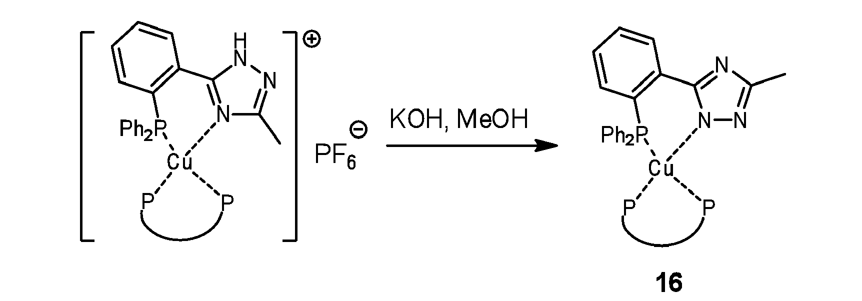

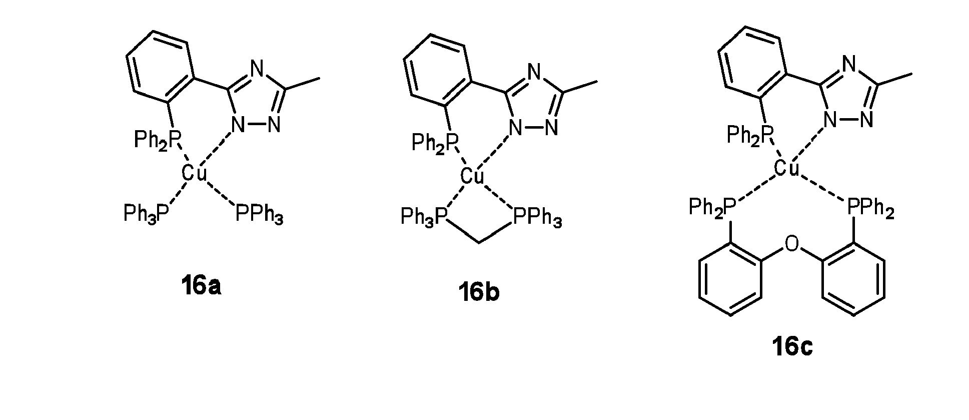

### Synthese der einfach negativ geladenen N∩L-Liganden

### Beispiel 9:

### 2-(2-Pyridinyl)-1H-indol, (N∩L)

1-(2-Pyrdinyl)ethanon wurde in einer Fischer-Indolsynthese mit Phenylhydrazin zu 2-(2-Pyridinyl)-1H-indol gemäß Literatur (R. P. Thummel, V. Hegde, J. Org. Chem. 1989, 54 (7), 1720) umgesetzt.

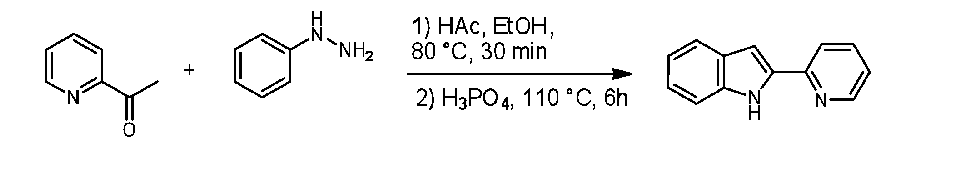

## Patentansprüche

1. Neutraler einkerniger Kupfer(I)komplex zur Emission von Licht mit einer Struktur gemäß Formel A 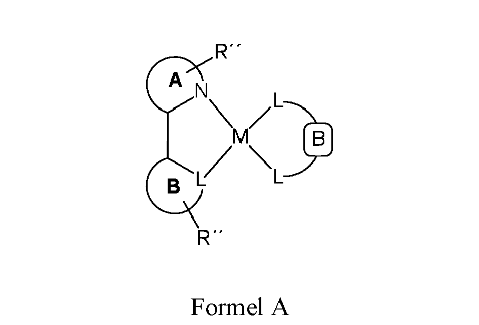 wobei 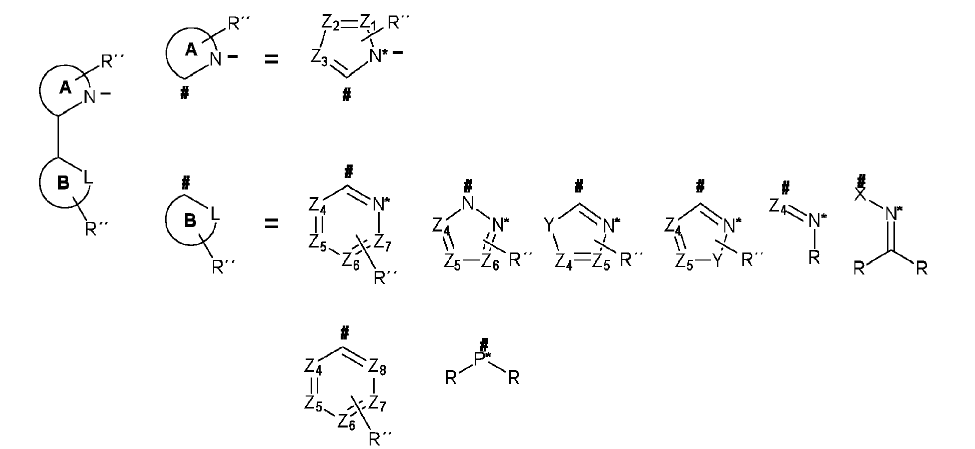 wobei gilt:
● M ist Cu(I);
● L-B-L: ein neutraler, zweizähniger Ligand, bevorzugt ein Phosphanyl- oder Arsanyl-Rest E*(R1)(R2), mit E = P oder As; R1, R2 können jeweils unabhängig voneinander Wasserstoff, Halogen sein oder Substituenten, die über Sauerstoff- (-OR), Stickstoff-(-NR₂) oder Siliziumatome (-SiR₃) gebunden sind sowie Alkyl- (auch verzweigt oder zyklisch), Aryl-, Heteroaryl-, Alkenyl-, Alkinyl-Gruppen bzw. substituierte Alkyl-(auch verzweigt oder zyklisch), Aryl-, Heteroaryl- und Alkenyl-Gruppen mit Substituenten wie Halogene oder Deuterium, Alkylgruppen (auch verzweigt oder zyklisch), und weitere allgemein bekannte Donor- und Akzeptor-Gruppen, wie beispielsweise Amine, Carboxylate und deren Ester, und CF₃-Gruppen, der über eine Brücke B mit einem weiteren Rest L verbunden ist und damit einen zweizähnigen Liganden bildet, wobei die Brücke B eine Alkylen- oder Arylen-Gruppe oder eine Kombination beider, oder -O-, -NR- oder -SiR₂- ist, wobei die Gruppen R1-R2 optional anellierte Ringsysteme bilden;
● Z1-Z7: besteht aus N oder dem Fragment CR,
mit R = organischer Rest, der ausgewählt ist aus der Gruppe bestehend aus:
Wasserstoff, Halogen oder Gruppen, die über Sauerstoff- (-OR), Stickstoff- (-NR₂), Silizium- (-SiR₃) oder Phosphoratome (-PR₂) gebunden sind sowie Alkyl- (auch verzweigt oder zyklisch), Aryl-, Heteroaryl-, Alkenyl-, Alkinyl-Gruppen bzw. substituierte Alkyl- (auch verzweigt oder zyklisch), Aryl-, Heteroaryl- und Alkenyl-Gruppen mit Substituenten wie Halogene oder Deuterium, Alkylgruppen (auch verzweigt oder zyklisch), und weitere allgemein bekannte Donor- und Akzeptor-Gruppen, wie beispielsweise Amine, Carboxylate und deren Ester, und CF₃-Gruppen;
● X ist entweder CR₂ oder NR;
● Y ist entweder O, S oder NR;
● Z8 besteht aus dem Fragment CR',
mit R' = OR, NR₂ oder PR₂, wobei die Bindung zum Cu-Atom dann über diese Gruppen erfolgt;
● R" ist ein sterisch anspruchsvoller Substituent, bevorzugt in ortho-Position zur Koordinationsstelle, der eine Geometrieveränderung in Richtung einer Planarisierung des Komplexes im angeregten Zustand verhindert, bevorzugt ein Alkylrest -(CH₂)ₙ-CH₃ (n = 0 - 20) (auch verzweigt), ein Arylrest mit 6 - 20 Kohlenstoffatomen (z. B. - Ph), Alkoxyrest -O-(CH₂)ₙ-CH₃ (n = 0 - 20), ein Aryloxyrest (z. B. -OPh) oder ein Silanrest (z. B -SiMe₃), wobei die Alkyl- und Arylreste auch substituiert sein können (z. B. mit Halogenen, Alkoxy- oder Silan-Gruppen) und optional zu annelierten Ringsystemen führen,
wobei Formel A keinen, einen oder zwei Reste R" aufweist;
● optional kann der Kupfer(I)komplex eine FG = Funktions-Gruppe (FG) als weiteren Substituenten aufweisen, die entweder direkt oder über geeignete Brücken an den N∩L -Substituenten gebunden ist, wobei die Funktionsgruppe ausgewählt ist aus der Gruppe bestehend aus Elektronenleiter, Lochleiter und Gruppen, die die Löslichkeit des Komplexes verändern, insbesondere die Löslichkeit in organischen Lösungsmitteln erhöhen;
● "*" kennzeichnet das Atom, das die Komplexbindung eingeht; und
● "#" kennzeichnet das Atom, das die Bindung mit der zweiten chemischen Einheit
vermittelt;
wobei der Kupfer(I)komplex optional
- einen ΔE(S₁-T₁)-Wert zwischen dem untersten angeregten Singulett (S₁)- und dem darunter liegenden Triplett (T₁)-Zustand von kleiner als 2500 cm⁻¹ aufweist;
- eine Emissionslebensdauer von höchstens 20 µs aufweist;
- eine Emissionsquantenausbeuten von größer 40 % aufweist, und/oder
- eine Löslichkeit in organischen Lösungsmitteln von mindestens 1 g/L, aufweist.

2. Kupfer(I)komplex nach Anspruch 1, wobei der N∩L Ligand ein optional substituierter Bisheteroaromat ist, der bevorzugt in ortho-Position zur Koordinationsstelle mit Substituenten wie Alkyl [CH₃-(CH₂)ₙ-] (n = 1 - 20) (optional verzweigt) oder Aryl (insbesondere Phenyl) substituiert ist.

3. Kupfer(I)komplex nach Anspruch 1 oder 2, wobei der sterisch anspruchsvolle Substituent R" zur Verhinderung der Planarisierung des Komplexes im angeregten Zustand ausgewählt ist aus der Gruppe bestehend aus:
Alkylresten -(CH₂)ₙ-CH₃ (n = 0 - 20) (optional verzweigt), Arylresten mit 6 - 20 Kohlenstoffatomen (z. B. -OPh), Alkoxyresten -O-(CH₂)ₙ-CH₃ (n = 0 - 20), Aryloxyresten (z. B. -OPh) und Silanresten (z. B -SiMe₃), ungesättigten Gruppen wie Alkenyl- und Alkinyl-Gruppen handeln, die wiederum optional mit Alkyl-Gruppen, Halogenen (F, Cl, Br, I), Silan-(-SiR"'₃) oder Ethergruppen -OR'' (R"' definiert wie R") substituiert sind;
wobei die Alkyl- und Arylreste optional substituiert und/oder zu anellierten Ringsystemen fusioniert sind.

4. Kupfer(I)komplex nach Anspruch 1 bis 3, wobei der sterisch anspruchsvolle Substituent R" die Löslichkeit des Kupfer(I)komplexes in organischen Lösungsmitteln erhöht und/oder die Loch- oder die Elektronenleitung erhöht.

5. Kupfer(I)komplex nach Anspruch 1 bis 4, wobei der sterisch anspruchsvolle Substituent R" zur Verhinderung der Planarisierung des Komplexes im angeregten Zustand eine aliphatische Gruppe in ortho-Position zur Koordinationsstelle ist.

6. Kupfer(I)komplex nach Anspruch 1 bis 5, wobei der Kupfer(I)komplex
- einen ΔE(S₁-T₁)-Wert von kleiner als 1500 cm⁻¹, bevorzugt von kleiner als 1000 cm⁻¹, besonders bevorzugt von kleiner als 500 cm⁻¹ aufweist;
- eine Emissionsquantenausbeuten von größer 40 %, bevorzugt größer 60 %, besonders bevorzugt größer 70 % aufweist;
- eine Emissionslebensdauer von höchstens 10 µs, bevorzugt kleiner 6 µs, besonders bevorzugt kleiner 3 µs aufweist; und/oder
- eine Löslichkeit in organischen Lösungsmitteln von mindestens 10 g/L aufweist.

7. Verwendung eines Kupfer(I)komplexes nach Anspruch 1 bis 6 zur Emission von Licht, insbesondere in einer Emitterschicht in einer opto-elektronischen Vorrichtung.

8. Verfahren zur Herstellung einer opto-elektronischen Vorrichtung,
wobei ein Kupfer(I)komplex nach Anspruch 1 bis 7 verwendet wird.

9. Verfahren zur Herstellung einer opto-elektronischen Vorrichtung nach Anspruch 8,
wobei die Herstellung nass-chemisch erfolgt und das Verfahren die folgenden Schritte aufweist:
- Aufbringung eines in einem ersten Lösungsmittel gelösten ersten Emitterkomplexes auf einen Träger, und
- Aufbringung eines in einem zweiten Lösungsmittel gelösten zweiten Emitterkomplexes auf den Träger;
wobei
- der erste Emitterkomplexes nicht in dem zweiten Lösungsmittel löslich ist und
- der zweite Emitterkomplexes nicht in dem ersten Lösungsmittel löslich ist;
und wobei der erste Emitterkomplex und/oder der zweite Emitterkomplex ein Kupfer(I)komplex nach Anspruch 1 bis 6 ist.

10. Verfahren nach Anspruch 9, wobei das Verfahren weiterhin den folgenden Schritt aufweist:
- Aufbringung eines in dem ersten Lösungsmittel oder in einem dritten Lösungsmittel gelösten dritten Emitterkomplexes auf den Träger,
wobei der dritte Kupfer(I)komplex ein Kupfer(I)komplex nach Anspruch 1 bis 6 ist.

11. Verfahren nach Anspruch 10, wobei die opto-elektronische Vorrichtung eine Weißlicht-OLED ist, wobei
- der erste Emitterkomplexe ein Rotlichtemitter ist,
- der zweite Emitterkomplexe ein Grünlichtemitter ist und
- der dritte Emitterkomplexe ein Blaulichtemitter ist.

12. Opto-elektronische Vorrichtung, aufweisend einen Kupfer(I)komplex nach den Ansprüchen 1 bis 7.

13. Opto-elektronische Vorrichtung nach Anspruch 12,
wobei der Anteil des Kupfer(I)komplexes in einer Emitterschicht 2 bis 100 Gew.-%, bevorzugt 4 bis 30 Gew.-%, bezogen auf das Gesamtgewicht der Emitterschicht, beträgt.

14. Opto-elektronische Vorrichtung nach Anspruch 12 oder 13 in Form einer organischen Leuchtdiode (OLED), **gekennzeichnet durch** einen Kupfer(I)komplex nach Anspruch 1 bis 7 aufweisende Emitterschicht, wobei der Anteil des Kupfer(I)komplexes in der Emitterschicht zwischen 2 bis 100 Gew.-%, bevorzugt 4 bis 30 Gew.-%, bezogen auf das Gesamtgewicht der Emitterschicht, beträgt.

15. Verwendung nach Anspruch 7, Verfahren nach Anspruch 8 bis 10, opto-elektronische Vorrichtung nach Anspruch 12 oder 13 wobei die opto-elektronische Vorrichtung ausgewählt ist aus der Gruppe bestehend aus organischen Leuchtidioden (OLEDs), lichtemittierenden elektrochemischen Zellen (LEECs oder LECs), OLED-Sensoren, insbesondere nicht hermetisch nach außen abgeschirmten Gas- und Dampf-Sensoren, optischen TemperaturSensoren, organischen Solarzellen (OSCs), organischen Feldeffekttransistoren, organischen Lasern, organischen Dioden, organischen Photodioden und "down conversion" Systemen.

16. Verfahren zur Auswahl von Cu(I)-Komplexen nach Anspruch 1 bis 6, deren ΔE(S₁-T₁)-Wert zwischen dem untersten angeregten Singulett- (S₁) und dem darunter liegenden Triplett-Zustand (T₁) kleiner als 2500 cm⁻¹, bevorzugt kleiner als 1500 cm⁻¹, besonders bevorzugt kleiner als 1000 cm⁻¹, ganz besonders bevorzugt kleiner 500 cm⁻¹ ist, **gekennzeichnet durch**
- Bestimmung des ΔE(S₁-T₁)-Wertes
- mittels einer ab-initio Molekülrechnung oder
- mittels Messung der Temperaturabhängigkeit der Fluoreszenz- und der Phosphoreszenz-Intensität oder
- mittels der Messung der Temperaturabhängigkeit der Emissionslebensdauer und
- Ermittlung der von organischen Molekülen, deren ΔE(S₁-T₁)-Wert kleiner als 2500 cm⁻¹, bevorzugt kleiner als 1500 cm⁻¹, besonders bevorzugt kleiner als 1000 cm⁻¹ , ganz besonders bevorzugt kleiner 500 cm⁻¹ist.
